# EUROPÄISCHE PATENTSCHRIFT

(11) **EP 4 279 933 B1**
(45) Veröffentlichungstag und Bekanntmachung des Hinweises auf die Patenterteilung: **18.03.2026**
(21) Anmeldenummer: 23163649.9
(22) Anmeldetag: 23.03.2023
(51) Int. Cl.: G01R 31/327, G01K 7/02

(54) **VORRICHTUNG UND VERFAHREN ZUR BESTIMMUNG EINES ALTERUNGSZUSTANDES MINDESTENS EINES LEISTUNGSHALBLEITERSCHALTERS**
DEVICE AND METHOD FOR DETERMINING AN AGING CONDITION OF AT LEAST ONE POWER SEMICONDUCTOR SWITCH
DISPOSITIF ET PROCÉDÉ DE DÉTERMINATION D'UN ÉTAT DE VIEILLISSEMENT D'AU MOINS UN COMMUTATEUR SEMI-CONDUCTEUR DE PUISSANCE

(30) Priorität: 16.05.2022 DE 102022204800
(43) Veröffentlichungstag der Anmeldung: 22.11.2023
(73) Patentinhaber: VOLKSWAGEN AG, 38440 Wolfsburg (DE)
(72) Erfinder: Arnaout, Samy, 34305 Niedenstein (DE); Schmäling, Jan, 34346 Hann. Münden (DE); Rang, Oliver, 34132 Kassel (DE)

(56) Entgegenhaltungen:
- EP-A2- 2 388 563
- EP-B1- 3 492 935
- DE-A1- 102015 223 470
- DE-A1- 102019 205 043
- DE-A1- 102020 214 678
- US-A1- 2014 125 366
- US-A1- 2019 033 362

## Beschreibung

Die Erfindung betrifft eine Vorrichtung und ein Verfahren zur Bestimmung eines Alterungszustandes mindestens eines Leistungshalbleiterschalters.

Leistungshalbleiterschalter werden vielfältig eingesetzt, beispielsweise in Traktionsnetzen für Elektro- oder Hybridfahrzeuge oder als Wechselrichter in Windkraftanlagen. Dabei ist es für den reibungsfreien Betrieb wichtig, möglichst vor einem Ausfall stark gealterte Leistungshalbleiterschalter wie MOSFET oder IGBTs zu identifizieren und auszutauschen.

Dabei ist es bekannt, dass sich mit zunehmendem Alterungszustand der Durchgangswiderstand erhöht. Dabei ist es weiter bekannt, dass der Durchgangswiderstand von der Temperatur und dem Durchlassstrom abhängig ist.

Aus der CN 112485632 A ist eine Vorrichtung zur Bestimmung eines Alterungszustandes eines IGBTs bekannt, wobei die Vorrichtung eine Auswerteeinheit und eine Temperaturerfassungseinrichtung aufweist. Dabei werden Spannung, Strom und Temperatur erfasst. Durch Vergleich mit abgespeicherten Kennlinien wird dann auf den Alterungszustand geschlossen.

Aus der EP 3 492 935 B1 ist ein Verfahren zur Bestimmung eines Alterungszustandes eines Leistungshalbleiterschalters bekannt, wobei der Spannungsabfall bei zwei verschiedenen Stromwerten bei gleicher Temperatur erfasst wird, wobei dies wiederholt wird, wobei aus den Messergebnissen ein Alterungszustand bestimmt wird.

Aus der US 2014/0125366 A1 ist ein Verfahren zur Bestimmung eines Alterungszustandes eines IGBTs bekannt, wobei der Spannungsabfall aufgrund eines vordefinierten Stromes zu einer eingestellten Temperatur ermittelt wird, wobei die Messung durchgeführt wird, wenn der IGBT nicht in Betrieb ist, wobei aus der Änderung der Spannungsabfälle auf den Alterungszustand geschlossen wird.

Aus der US 2019/0033362 A1 ist ein Verfahren zur Prognose eines Fehlers eines Leistungshalbleiterschalters bekannt.

Aus der DE 10 2019 205 043 A1 ist eine Transformatoreinrichtung mit mindestens einem Leistungsbauteil und mit einer Erfassungseinrichtung bekannt, die dazu eingerichtet ist, Spannungsmesswerte des Leistungsbauteils und Strommesswerte der Sekundärwicklung und/oder der Primärwicklung des Transformators zu erfassen. Dabei ist eine Auswerteeinrichtung vorhanden, die wenigstens eine erste dem Verschleiß kennzeichnende Größe aus einem Spannungs- und einem Strommesswert ermittelt. Dabei ist die Erfassungseinrichtung weiterhin dazu eingerichtet, die Temperaturmesswerte eines auf dem Leistungsbauteil angebrachten Temperaturfühlers zu erfassen und an die Auswerteeinrichtung zu übertragen. Die Auswerteeinrichtung ermittelt dann aus dem Temperaturverlauf eine zweite den Verschleiß kennzeichnende Größe.

Aus der DE 10 2015 223 470 A1 ist ein Halbleiterbauelement mit einem Substrat und einem ersten Temperaturmesselement bekannt, wobei das erste Temperaturmesselement in der Nähe eines Ortes großer Verlustleistung des Halbleiterbauelements angeordnet ist, wobei ein zweites Temperaturmesselement räumlich beabstandet von dem ersten Temperaturmesselement auf dem Substrat angeordnet ist. Aus den beiden Temperaturmesswerten wird dann ein Strom berechnet.

Aus der EP 2 388 563 A2 ist ein Verfahren zur Ermittlung der Temperatur eines Leistungshalbleiters bekannt, bei dem ein erster Steuerkontakt an einem ersten Pol eines im Leistungshalbleiter integrierten Vorwiderstandes angeschlossen ist, wobei ein zum Leistungshalbleiter weiterführender zweiter Pol des Vorwiderstandes zu einem zweiten Steuerkontakt geführt ist. Die Steuerkontakte sind dabei mit Anschlussklemmen verbunden, wobei durch Messung der Wert des Vorwiderstandes ermittelt wird und daraus mittels einer Kennlinie ein Temperaturwert ermittelt wird.

Aus der DE 10 2020 214 678 A1 ist ein weiteres Verfahren zum Abschätzen einer Sperrschichttemperatur eines Leistungshalbleiterbauelements bekannt.

Der Erfindung liegt das technische Problem zugrunde, eine Vorrichtung zur Bestimmung eines Alterungszustandes mindestens eines Leistungshalbleiterschalters zu schaffen, mittels derer die Genauigkeit verbessert werden kann. Ein weiteres Problem ist das Zurverfügungstellen eines entsprechenden Verfahrens.

Die Lösung des technischen Problems ergibt sich durch eine Vorrichtung mit den Merkmalen des Anspruchs 1 sowie ein Verfahren mit den Merkmalen des Anspruchs 7. Weitere vorteilhafte Ausgestaltungen der Erfindung ergeben sich aus den Unteransprüchen.

Hierzu weist die Vorrichtung zur Bestimmung eines Alterungszustandes mindestens eines Leistungshalbleiterschalters mindestens eine Auswerteeinheit und eine Einrichtung zur Erfassung oder Ermittlung einer Temperatur des Leistungshalbleiterschalters auf. Die Auswerteeinheit ist derart ausgebildet, auf Kennlinien eines Durchgangswiderstandes über den Alterungszustand zuzugreifen. Dabei ist Kennlinie allgemein als Zuordnungsvorschrift zu verstehen und umfasst auch Lookup-Tabellen. Die Kennlinien sind mit verschiedenen Temperaturen des Leistungshalbleiterschalters parametriert. Die Auswerteeinheit ist derart ausgebildet, einen Spannungswert über dem Leistungshalbleiterschalter bei einem vorgegebenen Stromwert durch den Leistungshalbleiterschalter in einem durchgeschalteten Zustand zu erfassen und daraus einen Durchgangswiderstand zu erfassen. Die Auswerteeinheit ordnet dann mit Hilfe der Kennlinien unter Berücksichtigung der erfassten oder ermittelten Temperatur dem Leistungshalbleiterschalter einen Alterungszustand zu. Dabei weist die Vorrichtung mindestens eine weitere Einrichtung zur Erfassung oder Ermittlung der Temperatur des Leistungshalbleiterschalters auf, wobei die Auswerteeinheit derart ausgebildet ist, die mittels der Einrichtung erfassten oder ermittelten Temperaturwerte des Leistungshalbleiterschalters mittels der von der mindestens einen weiteren Einrichtung erfassten oder ermittelten Temperaturwerte des Leistungshalbleiterschalters zu plausibilisieren und/oder anzupassen. Hierdurch kann die Alterungsbestimmung entsprechend verbessert werden. Dem liegt die Erkenntnis zugrunde, dass die Temperatur einen sehr großen Einfluss auf die Alterungsbestimmung hat, wobei diese nur schwer exakt zu bestimmen ist, wobei durch verschiedene Ursachen einzelne Temperaturmessungen verfälscht werden können. Durch die Möglichkeit, diese zu plausibilisieren, können Fehler leichter aufgefunden werden. Dabei sind verschiedenste Kombinationen der beiden Einrichtungen zur Erfassung oder Ermittlung der Temperatur möglich. Insbesondere können auch mehr als zwei Einrichtungen zur Anwendung kommen. Dabei kann beispielsweise die Einrichtung ein Temperatursensor sein, der direkt auf einem Substrat des Halbleiters oder direkt auf dem Clip angeordnet ist.

In einer Ausführungsform ist die Auswerteeinheit derart ausgebildet, dem Alterungszustand des Leistungshalbleiterschalters ein geschätztes Lebensdauerende zuzuordnen.

In einer weiteren Ausführungsform ist die Auswerteeinheit derart ausgebildet, bei einem Alterungszustand größer einem Schwellwert oder bei einem geschätzten Lebensdauerende kleiner einem Schwellwert ein Warnsignal zu erzeugen, sodass ein Austausch entsprechend rechtzeitig durchgeführt wird.

In einer weiteren Ausführungsform ist dem Leistungshalbleiterschalter mindestens ein Kühlkreislauf zugeordnet, auf dem mindestens ein Temperatursensor angeordnet ist, wobei die Auswerteeinheit derart ausgebildet ist, unter Berücksichtigung eines Volumenstromes des Kühlmittels aus den Werten des Temperatursensors eine Temperatur des Leistungshalbleiterschalters zu ermitteln. Dabei kann je nach Ausführungsform der Temperatursensor die Einrichtung oder die weitere Einrichtung zur Erfassung oder Ermittlung der Temperatur des Leistungshalbleiterschalters sein.

Gemäß der Erfindung ist der Leistungshalbleiterschalter als MOSFET ausgebildet, wobei die Vorrichtung derart ausgebildet ist, eine Gate-Threshold-Spannung unmittelbar vor und/oder nach dem Durchschalten des Leistungshalbleiterschalters zu ermitteln, wobei mittels einer Kennlinie der Gate-Threshold-Spannung eine Temperatur des Leistungshalbleiterschalters zugeordnet wird. Dies stellt ebenfalls eine Einrichtung zur Ermittlung der Temperatur dar, wobei die Einrichtung die erste Einrichtung sein kann der aber die mindestens eine weitere Einrichtung sein kann.

In einer weiteren Ausführungsform sind mehrere MOSFETs parallel geschaltet, wobei die Vorrichtung derart ausgebildet ist, die Gate-Threshold-Spannungen der einzelnen MOSFETs zu erfassen. Hierdurch ist es möglich, auf unterschiedliche Temperaturen der MOSFETs zu schließen, was wiederum ein Hinweis auf einen unterschiedlichen Alterungszustand sein kann, insbesondere wenn andere Ursachen für unterschiedliche lokale Temperaturen ausgeschlossen werden können. Die Gate-Threshold-Spannungen werden vorzugsweise durch ein oder mehrere Gate-Treiber-Bausteine ermittelt.

In einer weiteren Ausführungsform sind die MOSFETs als SiC-MOSFETs ausgebildet, die aufgrund ihrer derzeit noch kleinen Fläche häufig parallel geschaltet werden müssen, da der einzelne MOSFET über keine ausreichende Stromstrangfähigkeit verfügt.

Das Verfahren zur Bestimmung eines Alterungszustandes mindestens eines Leistungshalbleiterschalters erfolgt mittels einer Auswerteeinheit und einer Einrichtung zur Erfassung oder Ermittlung einer Temperatur des Leistungshalbleiterschalters. Dabei wird ein Spannungswert über dem Leistungshalbleiterschalter bei einem vorgegebenen Stromwert durch den Leistungshalbleiterschalter in einem durchgeschalteten Zustand erfasst und daraus ein Durchgangswiderstand berechnet. Mittels Kennlinien wird dem Durchgangswiderstand ein Alterungszustand des Leistungshalbleiterschalters unter Berücksichtigung der durch die Einrichtung erfassten oder ermittelten Temperatur zugeordnet. Weiter wird mittels einer weiteren Einrichtung zur Erfassung oder Ermittlung der Temperatur des Leistungshalbleiterschalters eine weitere Temperatur erfasst oder ermittelt, die zur Plausibilisierung und/oder Anpassung der durch die Einrichtung erfassten oder ermittelten Temperatur verwendet wird. Hinsichtlich der weiteren verfahrensmäßigen Ausgestaltungen wird vollinhaltlich auf die vorangegangenen Ausführungen Bezug genommen.

Die Erfindung wird nachfolgend anhand bevorzugter Ausführungsbeispiele näher erläutert. Die Figuren zeigen:
- Fig. 1: eine schematische Darstellung einer Vorrichtung zur Bestimmung eines Alterungszustandes mindestens eines Leistungshalbleiterschalters,
- Fig. 2: eine schematische Darstellung eines Durchgangswiderstandes über dem SOH,
- Fig. 3: eine schematische Darstellung einer Gate-Threshold-Spannung über der Temperatur und
- Fig. 4: eine schematische Darstellung einer Parallelschaltung von MOSFETs.

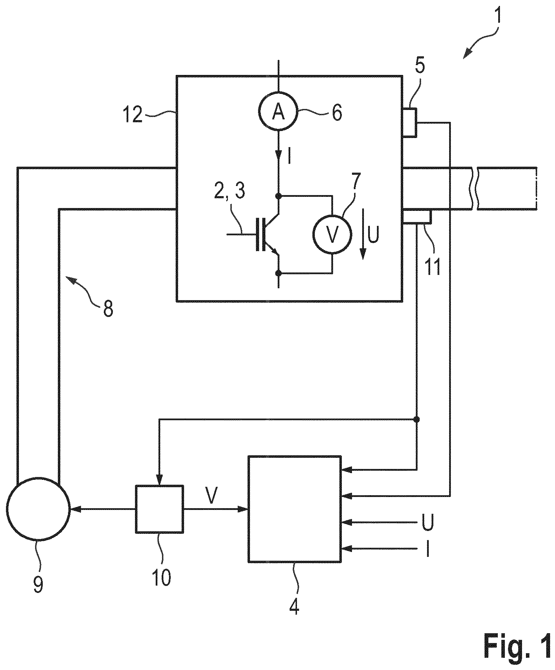

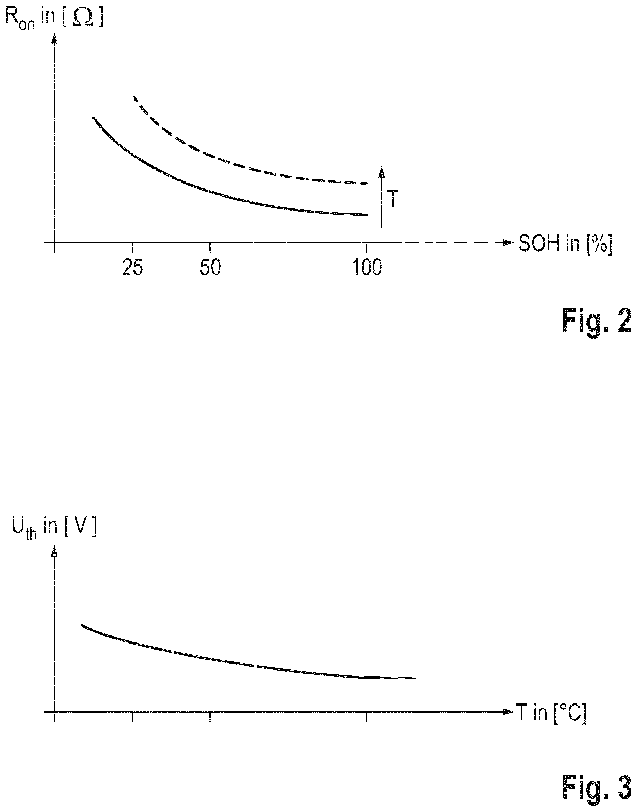

In der Fig. 1 ist schematisch eine Vorrichtung 1 zur Bestimmung eines Alterungszustandes mindestens eines Leistungshalbleiterschalters 2 dargestellt, der hier als IGBT 3 dargestellt ist. Die Vorrichtung 1 weist eine Auswerteeinheit 4 auf sowie eine Einrichtung 5 zur Erfassung oder Ermittlung einer Temperatur T des Leistungshalbleiterschalters 2. Weiter umfasst die Vorrichtung 1 eine Strommesseinrichtung 6, um den Strom I durch den Leistungshalbleiterschalter 2 zu erfassen. Die Position der Strommesseinrichtung 6 ist hier nur anschaulich dargestellt. Bei einem Pulswechselrichter wird vorzugsweise der Strom in den Mittelabgriffen zur Elektromaschine gemessen, da die Induktivitäten der Elektromaschine die schnellen Stromänderungen aufgrund der getakteten Arbeitsweise der Leistungshalbleiterschalter 2 drosseln. Aus diesem gemessenen Strom wird dann auf den Strom I durch den Leistungshalbleiterschalter geschlossen. Weiter weist die Vorrichtung 1 eine Spannungsmesseinrichtung 7 zur Erfassung der Spannung U über dem Leistungshalbleiterschalter 2 auf. Weiter ist ein Kühlkreislauf 8 dargestellt, wobei mittels einer Pumpe 9 Kühlmittel am Leistungshalbleiterschalter 2 vorbeigeführt werden kann, wobei der Kühlkreislauf nicht vollständig dargestellt ist. Die Pumpe 9 wird von einem Steuergerät 10 angesteuert. Auf einer Außenwandung des Kühlkreislaufes 8 ist eine weitere Einrichtung 11 zur Erfassung oder Ermittlung der Temperatur des Leistungshalbleiterschalters 2 beispielsweise in Form eines Temperatursensors angeordnet. Die Einrichtung 5 ist vorzugsweise ein Temperatursensor, der direkt auf einem Gehäuse 12 des Leistungshalbleiterschalters 2 angeordnet ist. Alternativ ist die Einrichtung 5 als Temperatursensor ausgebildet, der auf dem Substrat des Leistungshalbleiterschalters x2 oder auf dem Clip angeordnet ist. Die Auswerteeinheit 4 erhält die Temperaturwerte der Einrichtung 5 und der weiteren Einrichtung 11 sowie den Stromwert I und den Spannungswert U übermittelt. Des Weiteren erhält die Auswerteeinheit 4 einen Volumenstrom V des Kühlmittels vom Steuergerät 10 übermittelt. Zur Bestimmung des Alterungszustandes des Leistungshalbleiterschalters 2 wird im Betrieb der IGBT 3 durchgeschaltet und ein vorgegebener Strom I eingestellt. Der eingestellte Stromwert I und die resultierende Spannung U werden dann an die Auswerteeinheit übermittelt, die daraus einen Durchgangswiderstand Rₒₙ berechnet. Der Temperaturwert T, der von der Einrichtung 5 übermittelt wird, wird dann mittels des Temperaturwertes der Einrichtung 11 plausibilisiert und/oder angepasst. Weisen beispielsweise beide Einrichtungen 5, 11 eine große Genauigkeit auf, so kann beispielsweise eine Mittelwertbildung vorgenommen werden. Ist hingegen die Genauigkeit der Einrichtung 5 typischerweise genauer, so wird der Temperaturwert der Einrichtung 11 nur dazu verwendet, den Temperaturwert der Einrichtung 5 zu plausibilisieren. So kann beispielsweise ein Defekt der Einrichtung 5 festgestellt werden. Des Weiteren sind Fälle denkbar, wo benachbarte Wärmequellen die Temperaturmessung verfälschen können. Mit der plausibilisierten Temperatur der Einrichtung 5 wird dann in einer Kennlinie ein SOH-Wert (State-of-Health) ermittelt, wobei mit zunehmender Alterung der SOH-Wert kleiner wird (siehe auch Fig. 2), wobei die Kennlinien mit der Temperatur parametriert sind. Aus dem SOH-Wert bzw. dem Alterungszustand kann dann auf die verbleibende Lebensdauer bzw. das geschätzte Lebensdauerende bzw. das geschätzte Lebensdauerende geschlossen werden.

In der Fig. 3 ist schematisch der Zusammenhang zwischen der Gate-Threshold-Spannung Uₜₕ eines MOSFETs und der Temperatur T zeigt, wobei die Gate-Threshold-Spannung Uₜₕ mit der Temperatur T sinkt. Dies kann nun ausgenutzt werden, um eine Einrichtung 5 oder eine weitere Einrichtung 11 zu bilden. Kennt man die Gate-Threshold-Spannung, kennt man die Temperatur T.

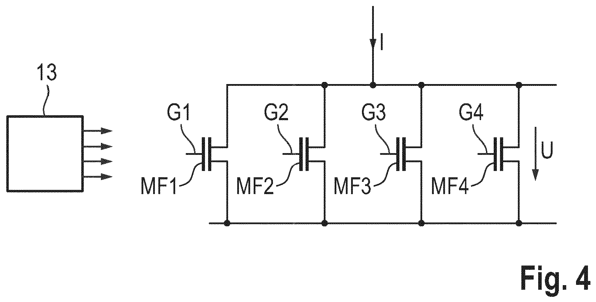

Dies ist insbesondere von Vorteil bei einer Schaltungskonfiguration wie in Fig. 4 dargestellt, wobei vier MOSFETs MF1-MF4 parallel geschaltet sind, wobei die MOSFETs MF1-MF4 beispielsweise als SiC-MOSFETs ausgebildet sind. Dabei wird häufig nur der Gesamt-Strom I gemessen und nur ein Temperatursensor für alle MOSFETs MF1-MF4 aus Platzgründen verbaut. Hierdurch ist der ermittelte Durchgangswiderstand Rₒₙ eine Mittelung, da davon ausgegangen wird, dass im Idealfall alle MOSFETs MF1-MF4 gleich sind und gleich altern, was im Realfall nicht zwingend ist. Steuert nun beispielsweise ein Gate-Treiber-Baustein 13 die einzelnen Gates G1-G4 individuell an, so kann dieser die jeweilige Gate-Threshold-Spannung Uₜₕ der MOSFETs MF1-MF4 ermitteln und somit den einzelnen MOSFETs MF1-MF4 eine individuelle Temperatur T gemäß dem Zusammenhang aus Fig. 3 zuordnen und die Alterung individuell für die MOSFETs MF1-MF4 bestimmen.

### Bezugszeichenliste

- 1: Vorrichtung
- 2: Leistungshalbleiterschalter
- 3: IGBT
- 4: Auswerteeinheit
- 5: Einrichtung
- 6: Strommesseinrichtung
- 7: Spannungsmesseinrichtung
- 8: Kühlkreislauf
- 9: Pumpe
- 10: Steuergerät
- 11: Einrichtung
- 12: Gehäuse
- 13: Gate-Treiber-Baustein
- T: Temperatur
- I: Strom
- U: Spannung
- V: Volumenstrom
- MF1-MF4: MOSFET
- Uₜₕ: Gate-Threshold-Spannung
- G1-G4: Gates

## Patentansprüche

1. Vorrichtung (1) zur Bestimmung eines Alterungszustandes mindestens eines Leistungshalbleiterschalter (2), wobei die Vorrichtung (1) mindestens eine Auswerteeinheit (4) und eine Einrichtung (5) zur Erfassung oder Ermittlung einer Temperatur (T) des Leistungshalbleiterschalters (2) aufweist, wobei die Auswerteeinheit (4) derart ausgebildet ist, auf Kennlinien eines Durchgangswiderstandes (Rₒₙ) über den Alterungszustand zuzugreifen, wobei die Kennlinien mit verschiedenen Temperaturen (T) des Leistungshalbleiterschalters (2) parametriert sind, wobei die Auswerteeinheit (4) weiter derart ausgebildet ist, einen Spannungswert (U) über dem Leistungshalbleiterschalter (2) bei einem vorgegebenen Stromwert (I) durch den Leistungshalbleiterschalter (2) in einem durchgeschaltetem Zustand zu erfassen und daraus einen Durchgangswiderstand (Rₒₙ) zu berechnen, wobei dann die Auswerteeinheit (4) unter Berücksichtigung der von der Einrichtung (5) erfassten oder ermittelten Temperatur (T) des Leistungshalbleiterschalters (2) mittels einer Kennlinie dem Leistungshalbleiterschalter (2) einen Alterungszustand zuordnet,
**dadurch gekennzeichnet, dass**
die Vorrichtung (1) mindestens eine weitere Einrichtung (11) zur Erfassung oder Ermittlung der Temperatur (T) des Leistungshalbleiters (2) aufweist, wobei die Auswerteeinheit (4) derart ausgebildet ist, die mittels der Einrichtung (5) erfassten oder ermittelten Temperaturwerte des Leistungshalbleiterschalters (2) mittels der von der mindestens einen weiteren Einrichtung (11) erfassten oder ermittelten Temperaturwerte des Leistungshalbleiterschalters (2) zu plausibilisieren und/oder anzupassen, wobei der Leistungshalbleiterschalter (2) als MOSFET (MF1-MF4) ausgebildet ist, wobei die Vorrichtung (1) derart ausgebildet ist, eine Gate-Threshold-Spannung (Uₜₕ) unmittelbar vor und/oder nach dem Durchschalten des Leistungshalbleiterschalters (2) zu ermitteln, wobei mittels einer Kennlinie der Gate-Threshold-Spannung (Uₜₕ) eine Temperatur (T) des Leistungshalbleiterschalters (2) zugeordnet wird.

2. Vorrichtung nach Anspruch 1, **dadurch gekennzeichnet, dass** die Auswerteeinheit (4) derart ausgebildet ist, dem Alterungszustand des Leistungshalbleiterschalters ein geschätztes Lebensdauerende zuzuordnen.

3. Vorrichtung nach Anspruch 1 oder 2, **dadurch gekennzeichnet, dass** die Auswerteeinheit (4) derart ausgebildet ist, bei einem Alterungszustand größer einem Schwellwert oder bei einem geschätzten Lebensdauerende kleiner einem Schwellwert ein Warnsignal zu erzeugen.

4. Vorrichtung nach einem der vorangegangenen Ansprüche, **dadurch gekennzeichnet, dass** dem Leistungshalbleiterschalter (2) mindestens ein Kühlkreislauf (8) zugeordnet ist, auf dem mindestens ein Temperatursensor zugeordnet ist, wobei die Auswerteeinheit (4) derart ausgebildet ist, unter Berücksichtigung eines Volumenstromes (V) des Kühlmittels aus den Werten des Temperatursensors eine Temperatur des Leistungshalbleiterschalters (2) zu ermitteln.

5. Vorrichtung nach einem der vorangegangenen Ansprüche, **dadurch gekennzeichnet, dass** mehrere MOSFETs (MF1-MF4) parallel geschaltet sind, wobei die Vorrichtung (1) derart ausgebildet ist, die Gate-Threshold-Spannungen (Uₜₕ) der einzelnen MOSFETs (MF1-MF4) zu erfassen.

6. Vorrichtung nach einem der vorangegangenen Ansprüche, **dadurch gekennzeichnet, dass** die MOSFETs (MF1-MF4) als SiC-MOSFETs ausgebildet sind.

7. Verfahren zur Bestimmung eines Alterungszustandes mindestens eines Leistungshalbleiterschalters (2), mittels einer Vorrichtung (1) umfassend mindestens eine Auswerteeinheit (4) und eine Einrichtung (5) zur Erfassung oder Ermittlung einer Temperatur (T) des Leistungshalbleiterschalters (2), wobei ein Spannungswert (U) über dem Leistungshalbleiterschalter (2) bei einem vorgegebenen Stromwert I) durch den Leistungshalbleiterschalter (2) in einem durchgeschalteten Zustand erfasst wird und daraus ein Durchgangswiderstand (Rₒₙ) berechnet wird, wobei mittels Kennlinien dem berechneten Durchgangswiderstand (Rₒₙ) ein Alterungszustand des Leistungshalbleiterschalters (2) unter Berücksichtigung der durch die Einrichtung erfassten oder ermittelten Temperatur (T) zugeordnet wird, **dadurch gekennzeichnet, dass** mittels mindestens einer weiteren Einrichtung (11) zur Erfassung oder Ermittlung der Temperatur (T) des Leistungshalbleiterschalters (2) eine weitere Temperatur (T) erfasst oder ermittelt wird, die zur Plausibilisierung und/oder Anpassung der durch die Einrichtung (5) erfassten oder ermittelten Temperatur verwendet wird, wobei der Leistungshalbleiterschalter (2) als MOSFET (MF1-MF4) ausgebildet ist, wobei die Vorrichtung (1) derart ausgebildet ist, eine Gate-Threshold-Spannung (Uₜₕ) unmittelbar vor und/oder nach dem Durchschalten des Leistungshalbleiterschalters (2) zu ermitteln, wobei mittels einer Kennlinie der Gate-Threshold-Spannung (Uₜₕ) eine Temperatur (T) des Leistungshalbleiterschalters (2) zugeordnet wird.

## Claims

1. Device (1) for ascertaining an aging condition of at least one power semiconductor switch (2), the device (1) comprising at least one evaluation unit (4) and an apparatus (5) for detecting or determining a temperature (T) of the power semiconductor switch (2), the evaluation unit (4) being designed to access characteristic curves of a contact resistance (Rₒₙ) via the aging condition, the characteristic curves being parameterized with different temperatures (T) of the power semiconductor switch (2), the evaluation unit (4) being further designed to detect a voltage value (U) across the power semiconductor switch (2) at a predetermined current value (I) via the power semiconductor switch (2) in a through-connected state and to calculate a contact resistance (Rₒₙ) from said voltage value, the evaluation unit (4) then assigning an aging condition to the power semiconductor switch (2) by means of a characteristic curve, taking into account the temperature (T) of the power semiconductor switch (2) detected or determined by the apparatus (5),
**characterized in that**
the device (1) comprises at least one further apparatus (11) for detecting or determining the temperature (T) of the power semiconductor (2), the evaluation unit (4) being designed to check the plausibility and/or adapt the temperature values of the power semiconductor switch (2) detected or determined by means of the apparatus (5), by means of the temperature values of the power semiconductor switch (2) detected or determined by the at least one further apparatus (11), the power semiconductor switch (2) being designed as a MOSFET (MF1-MF4), the device (1) being designed to determine a gate threshold voltage (Uₜₕ) immediately before and/or after the power semiconductor switch (2) is through-connected, the gate threshold voltage (Uₜₕ) being assigned a temperature (T) of the power semiconductor switch (2) by means of a characteristic curve.

2. Device according to claim 1, **characterized in that** the evaluation unit (4) is designed to assign an estimated end of service life to the aging condition of the power semiconductor switch.

3. Device according to claim 1 or claim 2, **characterized in that** the evaluation unit (4) is designed to generate a warning signal in the event of an aging condition greater than a threshold value or in the event of an estimated end of service life less than a threshold value.

4. Device according to any of the preceding claims, **characterized in that** the power semiconductor switch (2) is associated with least one cooling circuit (8),with which at least one temperature sensor is associated, the evaluation unit (4) being designed to determine a temperature of the power semiconductor switch (2) from the values of the temperature sensor, taking into account a volume flow (V) of the coolant.

5. Device according to any of the preceding claims, **characterized in that** a plurality of MOSFETs (MF1-MF4) are connected in parallel, the device (1) being designed to detect the gate threshold voltages (Uₜₕ) of the individual MOSFETs (MF1-MF4).

6. Device according to any of the preceding claims, **characterized in that** the MOSFETs (MF1-MF4) are designed as SiC MOSFETs.

7. Method for ascertaining an aging condition of at least one power semiconductor switch (2), by means of a device (1) comprising at least one evaluation unit (4) and an apparatus (5) for detecting or determining a temperature (T) of the power semiconductor switch (2), a voltage value (U) across the power semiconductor switch (2) being detected at a predetermined current value (I) via the power semiconductor switch (2) in a through-connected state, and a contact resistance (Rₒₙ) being calculated from said voltage value, the calculated contact resistance (Rₒₙ) being assigned an aging condition of the power semiconductor switch (2) by means of characteristic curves, taking into account the temperature (T) detected or determined by the apparatus,
**characterized in that**
by means of at least one further apparatus (11) for detecting or determining the temperature (T) of the power semiconductor switch (2), a further temperature (T) is detected or determined, which is used for the plausibility check and/or adaptation of the temperature detected or determined by the apparatus (5), the power semiconductor switch (2) being designed as a MOSFET (MF1-MF4), the device (1) being designed to determine a gate threshold voltage (Uₜₕ) immediately before and/or after the power semiconductor switch (2) is through-connected, the gate threshold voltage (Uₜₕ) being assigned a temperature (T) of the power semiconductor switch (2) by means of a characteristic curve.

## Revendications

1. Dispositif (1) permettant de déterminer un état de vieillissement d'au moins un commutateur à semi-conducteurs de puissance (2), dans lequel le dispositif (1) présente au moins une unité d'évaluation (4) et un appareil (5) pour la détection ou la détermination d'une température (T) du commutateur à semi-conducteurs de puissance (2), dans lequel l'unité d'évaluation (4) est configurée de sorte à accéder à des courbes caractéristiques d'une résistance traversante (Rₒₙ) concernant l'état de vieillissement, dans lequel les courbes caractéristiques sont paramétrées avec différentes températures (T) du commutateur à semi-conducteurs de puissance (2), dans lequel l'unité d'évaluation (4) est en outre configurée de sorte à détecter une valeur de tension (U) aux bornes du commutateur à semi-conducteurs de puissance (2) pour une valeur de courant (I) prédéfinie à travers le commutateur à semi-conducteurs de puissance (2) dans un état commuté et à calculer une résistance traversante (Rₒₙ) à partir de ladite valeur, dans lequel l'unité d'évaluation (4) associe alors un état de vieillissement au commutateur à semi-conducteurs de puissance (2) au moyen d'une courbe caractéristique en tenant compte de la température (T) du commutateur à semi-conducteurs de puissance (2) détectée ou déterminée par l'appareil (5),
**caractérisé en ce que**
le dispositif (1) présente au moins un autre appareil (11) pour la détection ou la détermination de la température (T) du commutateur à semi-conducteurs de puissance (2), dans lequel l'unité d'évaluation (4) est configurée de sorte à rendre plausibles et/ou à adapter les valeurs de température du commutateur à semi-conducteurs de puissance (2) détectées ou déterminées au moyen de l'appareil (5) au moyen des valeurs de température du commutateur à semi-conducteurs de puissance (2) détectées ou déterminées au moyen de l'au moins un autre appareil (11), dans lequel le commutateur à semi-conducteurs de puissance (2) est réalisé sous la forme d'un MOSFET (MF1-MF4), dans lequel le dispositif (1) est réalisé de sorte à déterminer une tension de seuil de grille (Uₜₕ) directement avant et/ou après la commutation du commutateur à semi-conducteurs de puissance (2), dans lequel une température (T) du commutateur à semi-conducteurs de puissance (2) est associée à la tension de seuil de grille (Uₜₕ) au moyen d'une courbe caractéristique.

2. Dispositif selon la revendication 1, **caractérisé en ce que** l'unité d'évaluation (4) est configurée de sorte à associer une fin de vie estimée à l'état de vieillissement du commutateur à semi-conducteurs de puissance.

3. Dispositif selon la revendication 1 ou 2, **caractérisé en ce que** l'unité d'évaluation (4) est configurée de sorte à générer un signal d'avertissement en cas d'état de vieillissement supérieur à une valeur seuil ou en cas de fin de vie estimée inférieure à une valeur seuil.

4. Dispositif selon l'une des revendications précédentes,
**caractérisé en ce qu'**au moins un circuit de refroidissement (8) est associé au commutateur à semi-conducteurs de puissance (2), auquel circuit de refroidissement est associé au moins un capteur de température, dans lequel l'unité d'évaluation (4) est configurée de sorte à déterminer une température du commutateur à semi-conducteurs de puissance (2) à partir des valeurs du capteur de température en tenant compte d'un débit volumique (V) du fluide de refroidissement.

5. Dispositif selon l'une des revendications précédentes,
**caractérisé en ce que** plusieurs MOSFET (MF1-MF4) sont montés en parallèle, dans lequel le dispositif (1) est configuré de sorte à détecter les tensions de seuil de grille (Uₜₕ) des MOSFET (MF1-MF4) individuels.

6. Dispositif selon l'une des revendications précédentes, **caractérisé en ce que** les MOSFET (MF1-MF4) sont réalisés en tant que MOSFET SiC.

7. Procédé permettant de définir un état de vieillissement d'au moins un commutateur à semi-conducteurs de puissance (2), au moyen d'un dispositif (1) comprenant au moins une unité d'évaluation (4) et un appareil (5) pour la détection ou la détermination d'une température (T) du commutateur à semi-conducteurs de puissance (2), dans lequel une valeur de tension (U) aux bornes du commutateur à semi-conducteurs de puissance (2) est détectée pour une valeur de courant (I) prédéfinie à travers le commutateur à semi-conducteurs de puissance (2) dans un état commuté et une résistance traversante (Rₒₙ) est calculée à partir de ladite valeur, dans lequel un état de vieillissement du commutateur à semi-conducteurs de puissance (2) est associé à la résistance traversante (Rₒₙ) calculée au moyen de courbes caractéristiques en tenant compte de la température (T) détectée ou déterminée par l'appareil,
**caractérisé en ce que**
au moyen d'au moins un autre appareil (11) pour la détection ou la détermination de la température (T) du commutateur à semi-conducteurs de puissance (2), une autre température (T) est détectée ou déterminée, laquelle est utilisée pour rendre plausible et/ou adapter la température détectée ou déterminée par l'appareil (5), dans lequel le commutateur à semi-conducteurs de puissance (2) est réalisé en tant que MOSFET (MF1-MF4), dans lequel le dispositif (1) est réalisé de sorte à déterminer une tension de seuil de grille (Uₜₕ) directement avant et/ou après la commutation du commutateur à semi-conducteurs de puissance (2), dans lequel une température (T) du commutateur à semi-conducteurs de puissance (2) est associée à la tension de seuil de grille (Uₜₕ) au moyen d'une courbe caractéristique.
